Europäisches Patentamt

European Patent Office

Office européen des brevets

(19)

(11) Publication number: 0 108 492

A2

(12) # EUROPEAN PATENT APPLICATION

(21) Application number: 83305941.3

(22) Date of filing: 30.09.83

(51) Int. Cl.³: H 01 M 10/46
H 01 L 31/02, H 01 L 25/0:

(30) Priority: 01.10.82 JP 170861/82

(43) Date of publication of application:
16.05.84 Bulletin 84/20

(84) Designated Contracting States:
CH DE FR GB IT LI NL

(71) Applicant: HITACHI, LTD.
6, Kanda Surugadai 4-chome Chiyoda-ku
Tokyo 100(JP)

(72) Inventor: Uda, Tsuyoshi
104-26 Suzukicho-1-chome
Kodaira-shi(JP)

(72) Inventor: Miyauchi, Katsuki
29-10 Hinohoncho-5-chome
Hino-shi(JP)

(72) Inventor: Maruyama, Eiichi
1572-3 Josuihoncho
Kodaira-shi(JP)

(72) Inventor: Shimada, Toshikazu
2196-178 Hirai Hinodecho
Nishitama-gun Tokyo(JP)

(72) Inventor: Murayama, Yoshimasa
2-1-320 Maeharacho-4-chome
Koganei-shi(JP)

(74) Representative: Paget, Hugh Charles Edward et al.
MEWBURN ELLIS & CO. 2/3 Cursitor Street
London EC4A 1BQ(GB)

(54) Composite photocell.

(57) A composite photocell including a solar cell and a secondary cell is disclosed in which the solar cell (1, 4, 5, 6, 7) is formed on one of a pair of main surfaces of a resin film (8) and the main body (5, 6, 7,) of the solar cell is made of micro-crystalline silicon containing hydrogen to decrease the number of recombination centers caused by interface strains and dangling bonds, and in which the secondary cell is provided on the other main surface of the resin film (8) and includes an anode (3) made of $TiS_2$, a solid electrolyte layer (9) made of $Li_4SiO_4 \cdot Li_3PO_4$ and a cathode (2) made of LiAl, to decrease the thickness of the secondary cell. This composite photocell can take the form of a card and is light in weight.

FIG. 2

EP 0 103 492 A2

Croydon Printing Company Ltd

0108492

## COMPOSITE PHOTOCELL

The present invention relates to a composite photocell provided with a charging mechanism, and more particularly to a thin, lightweight composite photocell capable of producing an electromotive force independently of lightness.

As is well known, a semipermanent composite cell which operates day and night, can be formed by using a solar cell as the charging source of a secondary cell. However, a conventional composite cell is required to include a strong substrate because of the structure of a secondary cell. Accordingly, it is impossible to make each of the thickness and weight of the composite cells smaller than a certain value. Further, since the solar cell does not serve as a satisfactory charging source of the secondary cell, it is not possible to completely recover the discharge current of the secondary cell, and therefore the life of the composite cell is limited.

It is an object of the present invention to provide a thin, lightweight composite cell which can operate semipermanently without artificial supplement of energy, e.g. without special charging operation.

It is another object of the present invention to provide a thin, lightweight composite cell capable of operating semipermanently without artificial supplement of energy, in which a secondary cell is charged by a solar cell.

According to the present invention, there is provided a composite photocell which comprises a solar cell provided on one of a pair of main surfaces of a substrate, and a thin-film secondary cell provided on the above-mentioned one main surface or the other main surface of the substrate.

Optional features and advantages of the present invention will become more apparent from the following detailed description taken in conjunction with the accompanying drawings, in which:

Fig. 1 is a graph showing the variation of electromotive force of a lithium cell with the discharge thereof; and

Figs. 2, 3A and 3B are sectional and diagramatic views showing embodiments of a composite photocell and a cash card according to the present invention.

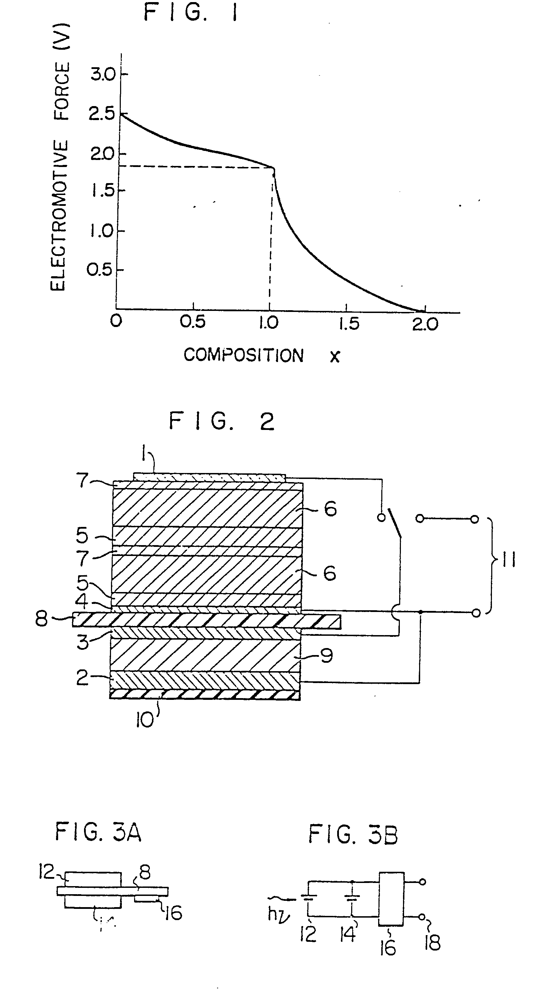

First, explanation will be made on the operation mechanism of a secondary cell (hereinafter referred to as a "Li cell"). The electromotive force of Li cell is generated in such a manner that a Li (lithium) atom in a cathode made of Li compounds such as LiSi and LiAl, passes through a solid electrolyte layer in the form of a Li ion, and then reaches an anode. In other words, the composition $Li_xTiS_2$ of the anode varies with the discharge of Li cell, that is, $x$ is changed from zero to 2. Further, as shown in Fig. 1, the electromotive force of Li cell is equal to ca. 2.5 V at x = 0, and then gradually decreases to become equal to 1.85 V at x = 1.0. When x exceeds 1.0, the electromotive force decreases abruptly.

A cell having an electromotive force of more than 2.5 V is used for charging the discharged Li cell. The direction of reaction in the charging process of the Li cell is opposite to that in the discharge process. That is, when the charging is made, a Li atom in the anode passes through the solid electrolyte layer in the form of a Li ion, and then reaches the cathode. In the case where the value of x is increased to more than 1 due to overdischarge, it is impossible to completely recover the electromotive force of the Li cell. However, in the case where x is less than 1, any deterioration of Li cell is not observed after charge and discharge have been repeated up to about one hundred times.

The above-mentioned fact that a cell having an electromotive force of about 2.5 V is required to charge the Li cell and the fact that the possibility of deterioration in the Li cell is prevented by charging the Li cell in a relatively short time, show that it is advantageous to use a solar cell as the power supply for charging the Li cell.

Next, it will be explained that micro-crystalline silicon containing hydrogen (hereinafter referred to as "u-Si:H") is advantageously used to form a solar cell. However, a material for making a solar cell according to the present invention is not limited to the

μ-Si:H in which hydrogen is added to the interface between micro-crystalline grains, to decrease the number of deep-level recombination centers caused by interface strains and dangling bonds, but the following materials may be used in place of the μ-Si:H. That is, polycrystalline silicon containing hydrogen, amorphous silicon (a-Si) which contains hydrogen to make long the life of photo-excited carrier on the basis of the above-mentioned decrease in the number of deep-level recombination centers, or a composite material in which the μ-Si:H and the a-Si:H coexist, may be used in place of the μ-Si:H.

The first advantage obtained when the μ-Si:H is used as the material of a solar cell, resides in that the open circuit voltage of the solar cell is as large as 0.9 to 1.3 V, and therefore a desired electromotive force can be obtained by connecting two or more solar cells in series or forming in one solar cell at least two pn junctions, pin junctions, or Schottky contacts. The second advantage resides in that the solar cell has a large absorption coefficient for light, and therefore the thickness of the solar cell can be made small. Further, the third advantage resides in that the solar cell can be formed at a relatively low temperature of 150 to 450°C, and therefore a substrate for supporting the solar cell can be made of various materials. It is needless to say that the solar cell may be made of the μ-Si:H by the conventional glow discharge method.

Not only the solar cell but also the Li cell has features that the cell is small in thickness and that various substrates can be used to support the cell. According to the present invention, the solar cell and Li cell are both deposited on the same substrate to make the best use of the above-mentioned features, and thus a thin, lightweight composite photocell is obtained.

Now, an embodiment of a composite photocell according to the present invention will be explained below, with reference to Fig. 2. Referring to Fig. 2, on one of a pair of main surfaces of a resin film 8 which is made of a resin material selected from the polyimide group and is heated to 300°C, is formed a $TiS_2$ electrode 3 through the CVD or plasma CVD method in which TiCl and $H_2S$ are used as the source gas. Thereafter, $Li_4SiO_4 \cdot Li_3PO_4$ is sputtered to form a solid electrolyte layer 9 on the electrode 3 heated to 150°C.

Next, an aluminum electrode 4 is formed on the other main surface of the resin film 8 heated to 150°C. Then, the resin film 8 used as a substrate is heated to 250°C, and a μ-Si:H layer is formed on the electrode 4 in the atmosphere of $H_2$ by the plasma CVD method in which silane $SiH_4$ is used as the source gas. In more detail, an n-type silicon layer 5 is first formed to a thickness of 50 nm by mixing phosphine $PH_3$ into the source gas. Then, a silicon layer 6 of intrinsic conductivity is formed to a thickness of 600 nm, and a p-type silicon layer 7 is formed on the layer 6 to a thickness of 15 nm

by mixing diborane $B_2H_6$ into the source gas. Such a process is twice repeated to form a μ-Si:H layer in which two pin structures overlap each other. In this case, however, the upper silicon layer 6 of intrinsic conductivity is formed to a thickness of 50 nm so as to realize high efficiency of photocurrent. Then, a transparent electrode 1, for example, a nesa film is formed on the μ-Si:H layer at about 150°C to complete a solar cell. Thus, the two cells are formed of deposited layers.

Thereafter, the substrate 8 is heated to 100°C, and a LiAl electrode 2 is formed on the solid electrolyte layer 9 which is made of $Li_4SiO_4 \cdot Li_3PO_4$. A collector electrode, for example, made of nickel Ni may be superposed on the LiAl electrode. A passivation film 10 made of $Si_3N_4$ or the like is formed on the LiAl or the composite electrode 2 at about 100°C. Finally, a pair of output terminals 11 are provided as shown in Fig. 2.

The total charge which can be taken out of the Li cell having the above-mentioned structure at one discharge process, corresponds to the change of the anode material from $TiS_2$ to $LiTiS_2$, and is determined by the volume of the anode 3. In more detail, an electric charge of 0.8 Ahr (ampere-hour) can be taken out of the Li cell when the $TiS_2$ electrode 3 has a volume of 1 $cm^3$. For example, when the $TiS_2$ electrode has an area of 10 $cm^2$ and a thickness of 1 μm, an electric charge of $0.8 \times 10^{-3}$ Ahr can be taken out of the Li cell, and the Li cell can be used for about 800 consecutive hours if a current of about 1 µA is caused to flow from the Li cell to the outside. On the other hand, when the solar cell having the above-mentioned structure is illuminated with the sunlight, a current of more than 100 mA can be taken out of the solar cell. Accordingly, it is possible to charge the Li cell in one minute. In case of rain or in the case where the composite photocell is placed in a room, it may take several hours to charge the Li cell. Actually, it is rare to operate the Li cell for 800 consecutive hours, and no problem arises if the Li cell is set to the charging

as shown in Fig. 2 during the period when the Li cell is not operated. In some cases, in order to prevent the electromotive force of the Li cell from decreasing to less than a critical value of 1.85 V and to prevent the Li cell from deteriorating on the basis of such a decrease in electromotive force, the composite photocell is required to have an alarm lamp which is turned on at a voltage approximately equal to the critical voltage.

In the above-mentioned embodiment, the Li cell is used as a main cell, and the solar cell as a power source for charging the Li cell. However, the solar cell may be used as the main cell and the Li cell as an auxiliary storage battery. Further, when the solar cell is combined with a Li primary cell, the life of the primary cell can be prolonged.

The efficiency of the solar cell made of a material which has either or both of the µ-Si:H and the a-Si:H as the matrix and further contains one or more than one species of carbon, germanium, tin, halogen, and others, can be improved. Group IV elements modifies the emf.

Such solar cells have been known. However, as a matter of course, such a solar cell can operate only when it is illuminated with light. In order to solve this problem, the solar cell is combined with a secondary cell capable of being charged. However, a strong substrate is indispensable for a conventional secondary cell because of the structure thereof, and therefore not only the thickness of the secondary cell becomes greater than 1.3 mm but also the weight thereof is increased. Further, the conventional secondary cell does not match the solar cell in electromotive force and current, and the composite photocell including the conventional secondary cell and the solar cell is relatively short in life.

According to the present invention, the above-mentioned drawbacks can be completely overcome. A main advantage of the present invention which is to be emphasized, is to be able to provide a composite photocell which has the form of a thin film and is light in weight.

Figs. 3A and 3B show an embodiment of a cash card with a built-in microcomputer. A silicon solar cell 12 and a Li cell 14 are similar to the foregoing embodiment. A utilization circuit 16 such as a microprocessor chip and terminals 18 are also provided to make small the quantity of information exchanged between a main computer and a terminal. Similarly, a composite photocell as described above is best suited for the built-in battery of the various cards. Further, a composite photocell as described above is suitable for a power supply for driving an ordinary electronic desk computer, and can be mounted on an artificial satellite.

The substrate for supporting the solar cell and Li cell may be formed of a rigid plate such as a glass plate, or a resin film made of polyimide or the like. Further, the substrate may be formed of metal foil which is made of a material selected from a group including titanium, niobium, vanadium, molybdenum, a stainless alloy, and others, or a flexible plate containing the resin film and metal foil. In this case, the electrode 4 for the solar cell can be dispensed with. Further, the deposition temperature may be raised for the modification of $TiS_2$ electrode characteristics.

0108492

CLAIMS:

1.        A composite photocell comprising:

a solar cell (1, 4, 5, 6, 7) capable of generating an electromotive force upon irradiation, formed of deposited layers and provided on one of a pair of main surfaces of a substrate (8); and

a thin-film cell (2, 3, 9) capable of storing electric charge, formed of deposited layers and provided on said one main surface or the other main surface of said substrate (8).

2.        A composite photocell according to Claim 1, wherein one of amorphous silicon, micro-crystalline silicon and polycrystalline silicon each containing hydrogen is used as the matrix of said solar cell, and junction or contact forming a potential barrier is formed, in said solar cell.

3.        A composite photocell according to claim 1 or claim 2 wherein said thin-film cell includes a solid electrolyte layer (9) having ionic conductivity caused by lithium ions.

4.        A composite photocell according to Claim 3, wherein said thin-film cell includes a cathode (2) made of a lithium compound, a solid electrolyte layer (9) made of $Li_4SiO_4 \cdot Li_3PO_4$, and an anode (3) made of $TiS_2$.

5.      A composite photocell according to any one of claims 1 to 4, wherein said substrate (8) is formed of one of a resin film, metal foil, and combinations thereof.

6.      A composite photocell according to claim 4 wherein said composite photocell is in the form of a card.

0108492

# FIG. 1

# FIG. 2

# FIG. 3A

# FIG. 3B